(19) Europäisches Patentamt
European Patent Office
Office européen des brevets

(11) **EP 3 576 285 A1**

(12) **EUROPÄISCHE PATENTANMELDUNG**

(43) Veröffentlichungstag:
04.12.2019  Patentblatt 2019/49

(51) Int Cl.:
*H02M 7/5395* (2006.01)      *H02P 27/08* (2006.01)
*B61L 21/06* (2006.01)      *H03K 17/567* (2006.01)

(21) Anmeldenummer: 18174844.3

(22) Anmeldetag: **29.05.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Bakran, Mark-Matthias**
**91052 Erlangen (DE)**

• **Böhmer, Jürgen**
**90547 Stein (DE)**
• **Helsper, Martin**
**90584 Allersberg (DE)**
• **Krafft, Eberhard Ulrich**
**90419 Nürnberg (DE)**
• **Laska, Bernd**
**91074 Herzogenaurach (DE)**
• **Nagel, Andreas**
**90431 Nürnberg (DE)**
• **Schönewolf, Stefan Hans Werner**
**90489 Nürnberg (DE)**
• **Weigel, Jan**
**91077 Großenbuch (DE)**

(54) **ENERGIEWANDLER**

(57)      Die Erfindung betrifft einen Energiewandler (20) zum Wandeln von elektrischer Energie, mit:
- wenigstens einem steuerbaren Schaltelement (28), das wenigstens einen schaltelementspezifischen Schaltzeitraum (40) bereitstellt, den das Schaltelement (28) benötigt, um abhängig von einem an einem Steueranschluss (30) des Schaltelements (28) bereitgestellten Schaltsignal (38) einen Schaltzustand einer Schaltstrecke (64) des Schaltelements (28) zwischen einem ausgeschalteten Schaltzustand und einem eingeschalteten Schaltzustand zu wechseln, sowie
- einer Steuereinheit (36), die ausgebildet ist, das Schaltsignal (38) derart bereitzustellen, dass das Schaltelement (28) zum Wandeln der elektrischen Energie abhängig vom Schaltsignal (38) in einem Schaltbetrieb betrieben wird, wobei
- die Steuereinheit (36) ferner ausgebildet ist, das Schaltsignal (38) in Bezug auf einen Zeitpunkt abhängig von dem wenigstens einen schaltelementspezifischen Schaltzeitraum (40) derart bereitzustellen, dass im bestimmungsgemäßen Betrieb des Energiewandlers (20) mit dem steuerbaren Schaltelement (28) wenigstens ein vorgebbarer Schaltzeitraum (42) an dem Zeitpunkt erreicht wird.

## FIG 4

EP 3 576 285 A1

**Beschreibung**

Die Erfindung betrifft einen Energiewandler zum Wandeln von elektrischer Energie, mit wenigstens einem steuerbaren Schaltelement, das wenigstens einen schaltelementspezifischen Schaltzeitraum bereitstellt, den das Schaltelement benötigt, um abhängig von einem an einem Steueranschluss des Schaltelements bereitgestellten Schaltsignal einen Schaltzustand einer Schaltstrecke des Schaltelements zwischen einem ausgeschalteten Schaltzustand und einem eingeschalteten Schaltzustand zu wechseln, sowie einer Steuereinheit, die ausgebildet ist, das Schaltsignal derart bereitzustellen, dass das Schaltelement zum Wandeln der elektrischen Energie abhängig vom Schaltsignal in einem Schaltbetrieb betrieben wird. Die Erfindung betrifft ferner ein Schaltelement für einen Energiewandler, mit wenigstens einem Steueranschluss zum Beaufschlagen mit einem Schaltsignal, und einer Schaltstrecke, die ausgebildet ist, einen Schaltzustand abhängig vom Schaltsignal am Steueranschluss bereitzustellen, wobei die Schaltstrecke wenigstens einen schaltelementspezifischen Schaltzeitraum bereitstellt, die das Schaltelement benötigt, um den Schaltzustand der Schaltstrecke zwischen einem ausgeschalteten Schaltzustand und dem eingeschalteten Schaltzustand zu wechseln. Weiterhin betrifft die Erfindung ein elektrisch antreibbares Fahrzeug, insbesondere ein schienengeführtes elektrisch antreibbares Fahrzeug, mit einer elektrischen Maschine zum Antreiben des Fahrzeugs, und wenigstens einem mit der elektrischen Maschine elektrisch gekoppelten Energiewandler. Schließlich betrifft die Erfindung auch ein Verfahren zum Betreiben eines Energiewandlers, der elektrische Energie wandelt, indem ein steuerbares Schaltelement in einem Schaltbetrieb betrieben wird, bei dem das steuerbare Schaltelement wenigstens einen schaltelementspezifischen Schaltzeitraum bereitstellt, die das Schaltelement benötigt, um abhängig von einem Schaltsignal einen Schaltzustand einer Schaltstrecke des Schaltelements zwischen einem ausgeschalteten Schaltzustand und einem eingeschalteten Schaltzustand zu wechseln, und das Schaltsignal derart bereitgestellt wird, dass das Schaltelement im Schaltbetrieb betrieben wird.

Energiewandler, steuerbare Schaltelemente, elektrisch antreibbare Fahrzeuge, insbesondere schienengeführte elektrisch antreibbare Fahrzeuge sowie Verfahren zum Betrieb von Energiewandlern sind dem Grunde nach im Stand der Technik umfänglich bekannt, sodass es eines gesonderten druckschriftlichen Nachweises hierfür nicht bedarf. Energiewandler der gattungsgemäßen Art werden eingesetzt, um elektrische Energie in vorgebbarer Weise zu wandeln. Energiewandler werden für eine Vielzahl von Energiewandlungsfunktionen in der Elektrotechnik genutzt. Derartige Energiewandler dienen zum Beispiel bei elektrisch antreibbaren schienengeführten Fahrzeugen sowie auch bei elektrisch antreibbaren Kraftfahrzeugen, die nicht schienengeführt sind, dazu, elektrische Energie für die unterschiedlichsten Antriebs- und Versorgungsfunktionen bereitzustellen. Die elektrische Energie wird bei schienengeführten Fahrzeugen häufig über eine oberhalb von zwei im Wesentlichen parallel angeordneten Schienen eines Gleises angeordnete Oberleitung zugeführt. Ein Gleis ist ein Fahrweg für ein schienengeführtes Fahrzeug. Die Anwendung von Energiewandlern ist jedoch nicht hierauf beschränkt. Energiewandler finden darüber hinaus auch vielseitigen Einsatz bei elektrisch antreibbaren Fahrzeugen, bei elektrischen Antriebssträngen, insbesondere bei Fertigungsanlagen, Herstellungsprozessen von Gütern und/oder dergleichen.

Insbesondere bei schienengeführten elektrisch antreibbaren Fahrzeugen ist es üblich, eine Kollision von Fahrzeugen unter anderem durch sogenannte Gleis-Frei-Meldeanlagen zu gewährleisten. Die Funktion solcher Gleis- Frei-Meldeanlagen basiert unter anderem darauf, einen elektrischen Widerstand zwischen den zwei das Gleis bildenden Schienen in einem vorgegebenen Gleisabschnitt zu ermitteln. Befindet sich in dem vorgegebenen Abschnitt ein Fahrzeug, so kann durch Ermitteln eines elektrischen Widerstands zwischen den beiden Schienen ermittelt werden, ob sich das Fahrzeug in dem vorgegebenen Abschnitt befindet. Der elektrische Widerstand wird durch Räder des Fahrzeugs beeinflusst, mit denen es auf den Schienen angeordnet ist. Gegenüberliegende Räder einer Achse des Fahrzeugs sind in der Regel elektrisch miteinander verbunden. Wird somit ein elektrischer Widerstand erfasst, der kleiner als ein vorgegebener Widerstandsvergleichswert ist, wird dies als Indiz dafür genutzt, dass sich das Fahrzeug in diesem Gleisabschnitt befindet. Ist der elektrische Widerstand dagegen größer als der vorgegebene Widerstandsvergleichswert, wird dies als Indiz dafür gewertet, dass sich kein Fahrzeug in dem vorgegebenen Gleisabschnitt befindet. Der vorgegebene Gleisabschnitt ist somit für die Nutzung von weiteren Fahrzeugen frei verfügbar.

Um eine zuverlässige Funktionalität der Gleis-Frei-Meldeanlage erreichen zu können, ist es in der Regel vorgesehen, zum Erfassen des Widerstands einen Gleichstrom und/oder einen Wechselstrom zu nutzen, wobei bei Nutzen eines Wechselstroms dieser eine oder mehrere vorgegebene Frequenzen nutzt, die im Bereich von bis zu etwa einigen kHz liegen können.

Befindet sich ein elektrisch angetriebenes Fahrzeug in dem vorgegebenen Gleisabschnitt in einem vorgegebenen Fahrbetrieb, so ist zu beachten, dass auf der für den bestimmungsgemäßen Betrieb des Fahrzeugs erforderliche elektrische Strom unter anderem über die Schienen geführt wird. Wenn dieser Strom, auch Traktionsstrom genannt, Frequenzanteile enthält, die auch von Gleis-Frei-Meldeanlagen genutzt werden, besteht das Problem, dass dieser Gleisabschnitt fälschlich als frei gemeldet werden kann.

Um diese relevante Fehlfunktion zu vermeiden, ist es bei elektrisch antreibbaren schienengeführten Fahrzeugen erforderlich, vorgegebene Grenzwerte im Bereich einer spektralen Verteilung des Traktionsstroms einzuhalten, und zwar insbesondere in spektralen Bereichen, die von der Gleis-Frei-Meldeanlage genutzt werden.

Unter Berücksichtigung dieses Sachverhalts sind für elektrisch antreibbare schienengeführt Fahrzeuge in der Regel getaktete Energiewandler konstruiert, die speziell die Funktionalität der Gleis-Frei-Meldeanlagen berücksichtigen. Dadurch kann erreicht werden, dass die Funktion von Gleis-Frei-Meldeanlagen durch den Betrieb des Energiewandlers im Wesentlichen nicht gestört wird.

Zu diesem Zweck sind in der Regel vorgegebene Impulsmuster vorgesehen, mit denen sichergestellt werden kann, dass Gleis-Frei-Meldeanlagen nicht gestört werden. Dies erfordert es, dass Schaltelemente des Energiewandlers im bestimmungsgemäßen Betrieb möglichst unverändert mit diesen Impulsmustern betrieben werden.

Wird nun im Rahmen einer Wartung eines elektrisch antreibbaren schienengebundenen Fahrzeugs auch der Energiewandler gewartet, beispielsweise indem eines oder mehrere Schaltelemente ausgetauscht werden, so kann das Einhalten der spektralen Verteilung durch den Traktionsstrom nur dann sichergestellt werden, wenn das Schaltelement im Wesentlichen identische Schaltverzugszeiten beziehungsweise Schaltzeiträume aufweist. Das Kriterium für einen Austausch des Schaltelements ist in diesem Fall also, dass vorgegebene Schaltverzugszeiten eingehalten werden, welche im Übrigen auch der Prüfung beziehungsweise Zertifizierung des elektrisch antreibbaren schienengebundenen Fahrzeugs zugrundeliegen.

Gerade elektrisch antreibbare schienengebundene Fahrzeuge sind jedoch über große Betriebszeiträume im Einsatz. Dies führt dazu, dass Schaltelemente als Austauschschaltelemente vorgesehen werden, die häufig nicht mehr die im Wesentlichen gleichen Schalteigenschaften aufweisen. Insbesondere zeigt es sich, dass Schaltzeiträume für solche Schaltelemente mit zunehmendem Entwicklungsfortschritt kleiner werden. Aus diesem Grund ist es derzeit im Stand der Technik üblich, bei einem Austausch eines Schaltelements eine Zulassung des Fahrzeugs mittels aufwendiger Störstrommessungen erneut nachzuweisen.

Dadurch ergibt sich, dass insbesondere ältere Schaltelemente nicht einfach durch neue Schaltelemente, die im Allgemeinen deutlich kleinere Schaltzeiträume bereitstellen, realisiert werden kann.

Die vorgenannte Problematik ist jedoch nicht auf schienengebundene Fahrzeuge begrenzt, sondern kann auch bei anderen elektrischen Einrichtungen auftreten, die Energiewandler nutzen. So kann sich durch ein neues Schaltelement ein anderes Verhalten in Bezug auf eine elektromagnetische Verträglichkeit, insbesondere auf eine Funkstörung, Netzrückwirkungen und/oder dergleichen ergeben.

Der Erfindung liegt die Aufgabe zugrunde, Probleme zu reduzieren, die sich aufgrund von sich verändernden Schaltzeiträumen von Schaltelementen ergeben können.

Als Lösung werden mit der Erfindung ein Energiewandler, ein Schaltelement, ein elektrisch antreibbares Fahrzeug sowie auch ein Verfahren gemäß den unabhängigen Ansprüchen vorgeschlagen.

Vorteilhafte Weiterbildungen ergeben sich durch Merkmale der abhängigen Ansprüche.

Bezüglich eines gattungsgemäßen Energiewandlers wird insbesondere vorgeschlagen, dass die Steuereinheit ausgebildet ist, das Schaltsignal in Bezug auf einen Zeitpunkt abhängig von dem wenigstens einen schaltelementspezifischen Schaltzeitraum derart bereitzustellen, dass im bestimmungsgemäßen Betrieb des Energiewandlers mit dem steuerbaren Schaltelement wenigstens ein vorgebbarer Schaltzeitraum an dem Zeitpunkt erreicht wird.

Bezüglich eines gattungsgemäßen Schaltelements wird insbesondere vorgeschlagen, dass das Schaltelement ausgebildet ist, das Schaltsignal in Bezug auf einen Zeitpunkt abhängig vom wenigstens einen schaltelementspezifischen Schaltzeitraum derart zeitlich zu beeinflussen, dass im bestimmungsgemäßen Betrieb des Energiewandlers mit dem steuerbaren Schaltelement wenigstens ein vorgebbarer Schaltzeitraum ab dem Zeitpunkt erreicht wird.

Bezüglich eines gattungsgemäßen elektrisch antreibbaren Fahrzeugs wird insbesondere vorgeschlagen, dass der Energiewandler gemäß der Erfindung ausgebildet ist oder der Energiewandler ein steuerbares Schaltelement aufweist, welches gemäß der Erfindung ausgebildet ist.

Bezüglich eines gattungsgemäßen Verfahrens wird insbesondere vorgeschlagen, dass das Schaltsignal in Bezug auf einen Zeitpunkt abhängig vom wenigstens einen schaltelementspezifischen Schaltzeitraum derart bereitgestellt wird, dass im bestimmungsgemäßen Betrieb des Energiewandlers mit dem steuerbaren Schaltelement wenigstens ein vorgebbarer Schaltzeitraum ab dem Zeitpunkt erreicht wird.

Die Erfindung basiert auf dem Gedanken, dass energiewandlerseitig sowie gegebenenfalls auch schaltelementseitig eine Anpassung bezüglich der Schalteigenschaften des Schaltelements vorgenommen werden kann, mit der erreicht werden kann, dass der wenigstens eine vorgebbare Schaltzeitraum auch zuverlässig eingehalten werden kann. Dabei kann mittels der Erfindung auf das Schaltsignal eingewirkt werden, sodass durch zeitliches Anpassen unter Berücksichtigung des schaltelementspezifischen Schaltzeitraums der vorgegebene Schaltzeitraum zuverlässig erreicht werden kann. Dadurch ist es möglich, unabhängig von schaltelementspezifischen Schaltzeiträumen des jeweils im Energiewandler vorgesehenen Schaltelements den vorgegebenen Schaltzeitraum zu realisieren, sodass im bestimmungsgemäßen Betrieb des Energiewandlers auftretende Rückwirkungen möglichst beibehalten werden können, wenn das Schaltelement des Energiewandlers ersetzt wird. Insbesondere kann erreicht werden, dass Netzrückwirkungen, eine Beeinflussung von Gleis-Frei-Meldeanlagen und/oder Beeinträchtigungen im Sinne der elektromagnetischen Verträglichkeit weitgehend unabhängig von einem aktuell im Energiewandler vorgesehenen Schaltelement realisiert werden können.

Das Schaltsignal wird also vorzugsweise derart bereitgestellt, dass ein Ende des vorgebbaren Schaltzeitraums mit einem Ende des schaltelementspezifischen Schaltzeitraums zusammenfällt. Es ist nämlich zu beachten, dass das Ende des Schaltzeitraums im praktischen Betrieb natürlich durch das Schaltelement bereitgestellt wird. Deshalb ist das Ende des vorgebbaren Schaltzeitraums durch das Ende des schaltelementspezifischen Schaltzeitraums bestimmt. Damit für den vorgebbaren Schaltzeitraum ein gewünschter Wert erreicht werden kann, kann deshalb das Schaltsignal entsprechend angepasst werden, sodass das Ende des vorgebbaren Schaltzeitraums mit dem Ende des schaltelementspezifischen Schaltzeitraums zusammenfällt. Das Ende kann also durch einen Zeitpunkt bestimmt sein.

Besonders vorteilhaft erweist sich die Erfindung dann, wenn der Energiewandler mehr als nur ein einziges Schaltelement aufweist, beispielsweise zwei Schaltelemente, vier Schaltelemente oder noch mehr Schaltelemente, die in geeigneter Weise zusammen mit entsprechenden Induktivitäten und/oder Kapazitäten zusammenwirken, um die gewünschte Energiewandlungsfunktionalität bereitstellen zu können.

Es ist es vorgesehen, dass die Steuereinheit für das wenigstens eine Schaltelement ein entsprechendes Schaltsignal bereitstellt, mittels dem es zum Zwecke des Energiewandelns durch den Energiewandler im vorgesehenen Schaltbetrieb betrieben werden kann. Bei mehreren Schaltelementen kann vorgesehen sein, dass entsprechend mehrere individuelle Schaltsignale für die einzelnen Schaltelemente vorgesehen sind. Natürlich kann auch vorgesehen sein, dass das Schaltsignal für zwei oder mehrere gemeinsam Schaltelemente genutzt wird. Dies ist unter anderem abhängig von einer Schaltungsstruktur des Energiewandlers.

Ein Schaltelement im Sinne dieser Offenbarung ist dabei vorzugsweise ein steuerbares elektronisches Schaltelement, beispielsweise ein steuerbarer elektronischer Halbleiterschalter wie ein Transistor, der in einem Schaltbetrieb betrieben wird, ein Thyristor, Kombinationsschaltungen hiervon, vorzugsweise mit parallelgeschalteten Inversdioden, ein Gateturn-off-Thyristor (GTO), ein Insulated-Gate-BipolarTransistor (IGBT), Kombinationen hiervon oder dergleichen. Dem Grunde nach kann das Schaltelement jedoch auch durch einen Feldeffekttransistor, insbesondere einen Metaloxide-Semiconductor-Field-Effect-Transistor (MOSFET) gebildet sein.

Zur Bereitstellung der gewünschten Energiewandlungsfunktionalität des Energiewandlers wird das wenigstens eine Schaltelement im Schaltbetrieb betrieben. In Bezug auf einen Halbleiterschalter nach Art eines Transistors bedeutet dies, dass in einem eingeschalteten Schaltzustand zwischen dem eine Schaltstrecke bildenden Anschlüssen des Transistors ein sehr kleiner elektrischer Widerstand bereitgestellt wird, sodass ein hoher Stromfluss bei sehr kleiner Restspannung möglich ist. In einem ausgeschalteten Schaltzustand ist hingegen die Schaltstrecke des Transistors hochohmig, das heißt, sie stellt einen hohen elektrischen Widerstand bereit, sodass auch bei hoher, an der Schaltstrecke anliegender elektrischer Spannung im Wesentlichen kein oder nur ein sehr geringer, insbesondere vernachlässigbarer, Stromfluss vorliegt. Hiervon unterscheidet sich ein Linearbetrieb bei Transistoren, der aber bei getakteten Energiewandlern in der Regel nicht zum Einsatz kommt.

Das Schaltelement weist zur Realisierung der Steuerfunktionalität wenigstens einen Steueranschluss auf, an dem es mit dem von der Steuereinheit bereitgestellten Schaltsignal beaufschlagbar ist, sodass die gewünschte Schaltfunktion des Schaltelements realisiert werden kann. Das Schaltsignal kann ein binäres Schaltsignal sein, welches zwei Zustandswerte einnehmen kann, um die gewünschten Schaltfunktionen des Schaltelements bereitstellen zu können. Beispielsweise kann das Schaltsignal durch eine Impulsfolge gebildet sein, mittels der der Steueranschluss beaufschlagt wird. Dies ist vor allem bei Thyristoren und GTO zweckmäßig. Darüber hinaus kann bei Transistoren vorgesehen sein, dass das Schaltsignal ein Rechtecksignal ist, wobei ein jeweiliger Schaltzustand des Schaltelements einem der Potentiale des Rechtecksignals zugeordnet werden kann. Ein solches Signal ist beispielsweise für Transistoren, insbesondere für bipolare Transistoren, Feldeffekttransistoren oder dergleichen zweckmäßig.

Die Steuereinheit stellt eine Funktionalität zum Erzeugen des Schaltsignals bereit. Auch weitere Funktionen des Energiewandlers können durch die Steuereinheit realisiert sein, beispielsweise Überwachungsfunktionen, Sicherheitsfunktionen und/oder dergleichen. Zu diesem Zweck kann die Steuereinheit eine Hardwareschaltung und/oder eine programmgesteuerte Rechnereinheit oder dergleichen umfassen.

Der Schaltzeitraum ist vorliegend ein Zeitraum, innerhalb dessen ein Wechsel zwischen den Schaltzuständen des Schaltelements erfolgt. Der Schaltzeitraum meint vorliegend also nicht einen Zeitraum, über den sich der eingeschaltete Schaltzustand oder auch der ausgeschaltete Schaltzustand erstreckt. Der schaltelementspezifische Schaltzeitraum bezeichnet somit einen Zeitraum, innerhalb dessen das Schaltelement zwischen den beiden Schaltzuständen wechselt, wenn am Steueranschluss ein entsprechendes Schaltsignal bereitgestellt wird. Der schaltelementspezifische Schaltzeitraum ist somit ein Zeitraum, der spezifisch von dem jeweiligen Schaltelement benötigt wird, um aufgrund des Schaltsignals den Schaltzustand in bestimmungsgemäßer Weise zu wechseln.

Dem Grunde nach kann der schaltelementspezifische Schaltzeitraum für ein jeweiliges Schaltelement ein im Wesentlichen konstanter Schaltzeitraum sein. Jedoch kann der schaltelementspezifische Schaltzeitraum auch von weiteren Parametern abhängig sein, die den bestimmungsgemäßen Betrieb des Schaltelements betreffen, beispielsweise dessen Temperatur, dessen Betriebsstrom im eingeschalteten Schaltzustand, dessen Betriebsspannung im ausgeschalteten Schaltzustand und/oder dergleichen.

Der vorgebbare Schaltzeitraum ist dagegen ein Zeitraum, der für den bestimmungsgemäßen Betrieb des Energiewandlers vorgegeben ist und der mittels des Schaltelements mit dem bestimmungsgemäßen Betrieb des Energiewandelns erreicht werden soll. Durch geeignetes Beeinflussen des Schaltsignals, entweder durch eine Steuereinheit und/oder auch durch das Schaltelement selbst, kann der vorgebbare Schaltzeitraum bei Kenntnis des schaltelementspezifischen Schaltzeitraums eingestellt werden. Zu diesem Zweck können entsprechende Anpassungsschaltungen und/oder Steuerungen vorgesehen sein, mittels denen das Schaltsignal in geeigneter Weise hinsichtlich seiner zeitlichen Lage angepasst werden kann, sodass der vorgegebene Schaltzeitraum trotz einem abweichenden schaltelementspezifischen Schaltzeitraum erreicht werden kann. Insgesamt ermöglicht es die Erfindung dadurch, bei Energiewandlern Schaltelemente nahezu beliebig austauschen zu können, ohne dessen spezifische Funktionalität, die für den vorgegebenen Schaltzeitraum erforderlich ist, wesentlich verändern zu müssen. Dadurch ist es insbesondere möglich, Schaltelemente, die einen sehr kurzen schaltelementspezifischen Schaltzeitraum aufweisen, zu nutzen, um Schaltelemente zu ersetzen, die einen großen schaltelementspezifischen Schaltzeitraum aufweisen. Dies berücksichtigt, dass mit zunehmendem Entwicklungsfortschritt Schaltelemente kürzere schaltelementspezifische Schaltzeiträume aufweisen. Die Wartung des Energiewandlers kann dadurch insgesamt vereinfacht werden.

Darüber hinaus kann durch die Erfindung erreicht werden, dass für den bestimmungsgemäßen Betrieb des Energiewandlers einzuhaltende technische Anforderungen, beispielsweise Netzrückwirkungen, Anforderungen hinsichtlich der elektromagnetischen Verträglichkeit und/oder dergleichen auch durch ein Austauschen des wenigstens einen Schaltelements im Wesentlichen nicht beeinträchtigt zu werden brauchen. Dadurch ist es auch nicht mehr erforderlich, den Energiewandler nach einer Wartung, insbesondere einem Austausch des wenigstens einen Schaltelements, erneut hinsichtlich seiner Eigenschaften zu prüfen beziehungsweise zu zertifizieren.

In Bezug auf den Warnbetrieb von Gleis-Frei-Meldeanlagen kann somit auch erreicht werden, dass elektrisch antreibbare schienengebundene Fahrzeuge nach einer Wartung beziehungsweise nach einem Austausch eines Schaltelements eines Energiewandlers des Fahrzeugs nicht mehr erneut geprüft beziehungsweise zertifiziert zu werden brauchen. Vielmehr kann durch die Erfindung erreicht werden, dass die im Stand der Technik auftretenden unerwünschten Eigenschaften, beispielsweise in Bezug auf Gleis-Frei-Meldeanlagen, reduziert, wenn nicht sogar vollständig vermieden werden können.

Dem Grunde nach ist dies natürlich nicht auf den Warnbetrieb beschränkt, sondern kann auch für andere Antriebssituationen, beispielsweise elektrisch antreibbare Kraftfahrzeuge, elektrische Antriebsstränge und/oder dergleichen, entsprechend genutzt werden.

Insbesondere kann natürlich vorgesehen sein, dass der Energiewandler mehrere Schaltelemente aufweist, wobei die Schaltelemente unterschiedliche schaltelementspezifische Schalteigenschaften bereitstellen können. Auch in diesem Fall kann eine entsprechende Anpassung realisiert werden. Zu diesem Zweck ist vorzugsweise vorgesehen, dass für jedes der Schaltelemente eine eigene entsprechende Anpassung gemäß der Erfindung realisiert ist.

Es wird ferner vorgeschlagen, dass der Energiewandler eine Kommunikationsverbindung zwischen der Steuereinheit und dem Schaltelement aufweist, die ausgebildet ist, Daten bezüglich des wenigstens einen schaltelementspezifischen Schaltzeitraums und/oder des wenigstens einen vorgebbaren Schaltzeitraums zwischen der Steuereinheit und dem Schaltelement zu übermitteln. Dadurch kann erreicht werden, dass steuereinheitsseitig die spezifischen funktionellen Daten des Schaltelements, insbesondere in Bezug auf den schaltelementspezifischen Schaltzeitraum, verfügbar sind. Die Steuereinheit kann somit das Schaltsignal in entsprechender Weise bereitstellen.

Ist hingegen eine Anpassungsfunktionalität schaltelementseitig vorgesehen, kann die Steuereinheit den vorgebbaren Schaltzeitraum an das Schaltelement übermitteln, sodass es aufgrund eines Schaltsignals seine Schaltfunktionalität entsprechend adaptieren kann. Natürlich können auch Kombinationen hiervon vorgesehen sein. Die Daten können entweder in regelmäßigen Abständen oder auch lediglich einmalig bereitgestellt werden, damit die Steuereinheit beziehungsweise das Schaltelement eine entsprechende Einstellung vorzunehmen vermag. Es kann zum Beispiel vorgesehen sein, dass steuereinheitsseitig und/oder schaltelementseitig die entsprechenden Daten für den Gebrauch gespeichert werden.

Zu diesem Zweck kann zum Beispiel vorgesehen sein, dass die Steuereinheit eine Speichereinheit mit den Werten bezüglich des wenigstens einen schaltelementspezifischen Schaltzeitraums und/oder des wenigstens einen vorgebbaren Schaltzeitraums umfasst. Entsprechendes kann natürlich auch für das Schaltelement vorgesehen sein. Dadurch kann steuereinheitsseitig erreicht werden, dass das Schaltsignal unter Berücksichtigung der vorgenannten Schaltzeiten bereitgestellt wird.

Schaltelementseitig kann dagegen vorgesehen sein, dass das Schaltsignal am Steueranschluss entsprechend ausgewertet wird, sodass der vorgebbare Schaltzeitraum erreicht werden kann. Es braucht in diesem Fall also nicht unbedingt eine Anpassung durch die Steuereinheit vorgenommen zu werden. Vielmehr kann bei dieser Ausgestaltung erreicht werden, dass das Schaltelement im Falle der Wartung des Energiewandlers lediglich unmittelbar ausgetauscht zu werden braucht.

Weiterhin wird vorgeschlagen, dass die Steuereinheit ausgebildet ist, dem wenigstens einen schaltelementspezifischen Schaltzeitraum und/oder dem wenigstens einen vorgebbaren Schaltzeitraum entsprechende Daten aus einer Datenbank abzurufen, die mit der Steuereinheit zumindest zeitweise in Kommunikationsverbindung steht. Dadurch brauchen die entsprechenden Daten nicht unmittelbar in der Steuereinheit beziehungsweise dem Schaltelement vorgehalten zu werden. Sie können bedarfsweise von der Datenbank abgerufen werden. Zu diesem Zweck kann die Kommunikationsverbindung ein Kommunikationsnetzwerk wie das Internet oder dergleichen nutzen.

Dem Grunde nach besteht allerdings auch die Möglichkeit, die Steuereinheit beziehungsweise das Schaltelement spezifisch einzustellen, beispielsweise indem eine Programmierung oder auch eine Justierung der Steuereinheit beziehungsweise des Schaltelements entsprechend vorgesehen wird. Dies kann zum Beispiel manuell oder auch mittels Einstellautomaten oder dergleichen erfolgen. In diesem Fall ist natürlich eine Kommunikationsverbindung nicht zwingend erforderlich. Trotzdem kann dies natürlich auch mit den vorgenannten Optionen kombiniert sein.

Gemäß einer Weiterbildung wird vorgeschlagen, dass die Steuereinheit ausgebildet ist, das Steuersignal abhängig vom wenigstens einen schaltelementspezifischen Schaltzeitraum und/oder vom wenigstens einen vorgebbaren Schaltzeitraum zu ermitteln. In dieser Ausgestaltung wird das Schaltsignal also nicht unbedingt nur zeitlich hinsichtlich seiner Lage angepasst, sondern es wird ein gänzlich neues Steuersignal erzeugt, das bereits die entsprechende zeitliche Lage aufweist. Dies kann durch eine entsprechende Berechnung unter Berücksichtigung des schaltelementspezifischen Schaltzeitraums und/oder des vorgebbaren Schaltzeitraums erfolgen. Die Berechnung kann für den bestimmungsgemäßen Betrieb des Energiewandlers zu vorgebbaren Zeitpunkten wiederholt werden. Natürlich kann insbesondere auch vorgesehen sein, dass zu jedem Wechsel des Schaltzustands des Schaltelements eine entsprechende Berechnung beziehungsweise Adaption erfolgt.

Der wenigstens eine Schaltzeitraum ist vorzugsweise ein Einschaltzeitraum und/oder ein Ausschaltzeitraum. Für den wenigstens einen Einschaltzeitraum und/oder für den wenigstens einen Ausschaltzeitraum können entsprechend unterschiedliche vorgebbare Schaltzeitenräume vorgesehen beziehungsweise zugeordnet sein. Entsprechend kann eine Anpassung des Schaltsignals für den Einschaltzeitraum und/oder den Ausschaltzeitraum erfolgen. Insbesondere kann vorgesehen sein, dass der Einschaltzeitraum und der Ausschaltzeitraum separat voneinander erzeugt werden. Dies kann schaltelementspezifische Eigenschaften berücksichtigen, mittels denen ein Ausschaltverhalten und ein Einschaltverhalten unterschiedlich voneinander ausfallen können. Die Anpassung kann dadurch insgesamt verbessert werden.

Schaltelementseitig kann insbesondere ein Kommunikationsstellenanschluss zum Übermitteln der Daten bezüglich des vorgebbaren Schaltzeitraums und/oder des schaltelementspezifischen Schaltzeitraums vorgesehen sein. Auf diese Weise ist es der Steuereinheit oder einer externen Datenquelle wie der Datenbank möglich, die entsprechenden Daten für das Schaltelement zur Verfügung zu stellen. Insbesondere kann vorgesehen sein, dass der schaltelementspezifische Schaltzeitraum an das Schaltelement übermittelt wird, damit diesem die Daten schaltelementspezifisch zur Verfügung stehen. Dies berücksichtigt, dass das Schaltelement unter Umständen nicht dazu ausgebildet ist, selbsttätig den schaltelementspezifischen Schaltzeitraum ermitteln zu können. Hierfür kann es sinnvoll sein, dass die entsprechenden Daten bereits bei der Herstellung des Schaltelements an das Schaltelement übermittelt und dort gespeichert werden können. Dem Grunde nach gilt dies natürlich auch für den vorgebbaren Schaltzeitraum, der insbesondere von der Steuereinheit, in deren Energiewandler das Schaltelement angeordnet ist, bereitgestellt wird. Dadurch ist es möglich, das Schaltelement auch nach seiner Herstellung an eine nahezu beliebige Nutzung in einem Energiewandler entsprechend anpassen zu können. Das Schaltelement braucht also in dieser Ausgestaltung kein für einen jeweiligen Energiewandler spezifisches Schaltelement zu sein, sondern es kann ein Standardschaltelement genutzt werden, welches unter Nutzung der entsprechenden vorgenannten Daten spezifisch an die Nutzung in dem jeweiligen Energiewandler angepasst werden kann. Dadurch kann die Flexibilität insgesamt weiter erhöht werden.

Es kann ferner vorgesehen sein, dass das Schaltsignal ergänzend abhängig von einem elektrischen Strom und/oder einer elektrischen Spannung und/oder einer Temperatur des Energiewandlers, insbesondere des Schaltelements, ermittelt wird. Diese Weiterbildung berücksichtigt, dass der schaltelementspezifische Schaltzeitraum auch von einem bestimmungsgemäßen Betrieb des Energiewandlers beziehungsweise des Schaltelements innerhalb des Energiewandlers abhängig sein kann. Beispielsweise kann der schaltelementspezifische Schaltzeitraum von einem Betriebsstrom während des eingeschalteten Schaltzustands abhängig sein. Der schaltelementspezifische Schaltzeitraum kann darüber hinaus jedoch auch von einer Spannung abhängig sein, die zum Beispiel in einem ausgeschalteten Schaltzustand des Schaltelements an dessen Schaltstrecke anliegt. Auch Kombinationen hiervon können vorgesehen sein. Dadurch kann die Funktionalität des Schaltelements innerhalb des Energiewandlers weiter verbessert werden.

Vorzugsweise ist der wenigstens eine vorgebbare Schaltzeitraum größer als der wenigstens eine schaltelementspezifische Schaltzeitraum. Dadurch kann erreicht werden, dass eine einfache Anpassung durch zum Beispiel eine zeitliche Verzögerung mittels einer Verzögerungseinheit oder dergleichen erreicht werden kann. Auf diese Weise kann eine besonders einfache Anpassung erreicht werden. Darüber hinaus berücksichtigt diese Weiterbildung den Sachverhalt, dass mit zunehmendem Entwicklungsfortschritt die Schaltelemente in der Regel schnellere schaltelementspezifische Schaltzeiträume bereitstellen, sodass ein Wechsel eines Schaltelements über einen Energiewandler in der Regel dazu führt, dass der schnellere schaltelementspezifische Schaltzeitraum des neuen Schaltelements entsprechend zu kompensieren ist. Dem Grunde nach ist natürlich auch ein umgekehrter Fall möglich, wobei dann jedoch vorzugsweise unter Nutzung der Steuereinheit das Schaltsignal entsprechend zeitlich vorgezogen wird, sodass der vorgebbare Schaltzeitraum auch hier noch erreicht werden kann. Natürlich können auch unterschiedlichste Kombinationen hiervon vorgesehen sein.

Es kann ferner vorgesehen sein, dass der wenigstens eine schaltelementspezifische Schaltzeitraum in einem bestimmungsgemäßen Betrieb des Energiewandlers ermittelt wird. Der bestimmungsgemäße Betrieb kann zum Beispiel in einem Testlauf, während einer Prüfphase und/oder dergleichen erfolgen. Die entsprechenden Daten des schaltelementspezifischen Schaltzeitraums können dann der Steuereinheit und/oder dem Schaltelement zur Verfügung gestellt werden. Darüber hinaus kann natürlich auch vorgesehen sein, dass das Schaltelement und/oder die Steuereinheit entsprechend angepasst werden, sodass der vorgebbare Schaltzeitraum erreicht werden kann.

Die für den erfindungsgemäßen Energiewandler angegebenen Vorteile und Wirkungen gelten natürlich gleichermaßen für das erfindungsgemäße Schaltelement sowie das erfindungsgemäße Verfahren und umgekehrt. Insbesondere können natürlich Vorrichtungsmerkmale als Verfahrensmerkmale und umgekehrt formuliert sein.

Weitere Vorteile und Merkmale ergeben sich aus der folgenden Beschreibung eines Ausführungsbeispiels anhand der beigefügten Figuren. In den Figuren bezeichnen gleiche Bezugszeichen gleiche Merkmale und Funktionen.

Es zeigt:

FIG 1     eine schematische Blockdarstellung eines elektrisch antreibbaren Bahnfahrzeugs auf einem zwei in Längsrichtung parallel angeordnete Schienen aufweisenden Gleis,

FIG 2     eine schematische Diagrammdarstellung eines Schaltsignals für ein Schaltelement eines Energiewandlers des Bahnfahrzeugs gemäß FIG 1,

FIG 3     eine schematische Diagrammdarstellung von Schaltsignalen des Schaltelements wie die FIG 2,

FIG 4     eine vergrößerte Diagrammdarstellung aus FIG 3 für einen Einschaltvorgang,

FIG 5     eine schematische Diagrammdarstellung einer spektralen Verteilung eines Stroms des Schaltelements gemäß FIG 3 mit einem schaltelementspezifischen Schaltzeitraum eines ersten Schaltelements, der einem vorgebbaren Schaltzeitraum entspricht,

FIG 6     eine schematische Diagrammdarstellung wie FIG 5, jedoch für ein zweites Schaltelement mit einem kleineren schaltelementspezifischen Schaltzeitraum als das erste Schaltelement, welches dem Diagramm gemäß FIG 5 zugrundeliegt,

FIG 7     eine schematische Diagrammdarstellung eines Spannungs-Zeit-Diagramms für ein vorgebbares Schaltsignal,

FIG 8     eine schematische Darstellung wie FIG 7 für einen schaltelementspezifischen Schaltzeitraum,

FIG 9     eine schematische Diagrammdarstellung wie FIG 8, 9 zum Ermitteln einer Verzögerungszeit für das Schaltsignal einer Steuereinheit zum Steuern des Schaltelements, und

FIG 10    eine schematische Blockdarstellung für eine Realisierung der Erfindung mittels einer Verzögerungseinheit.

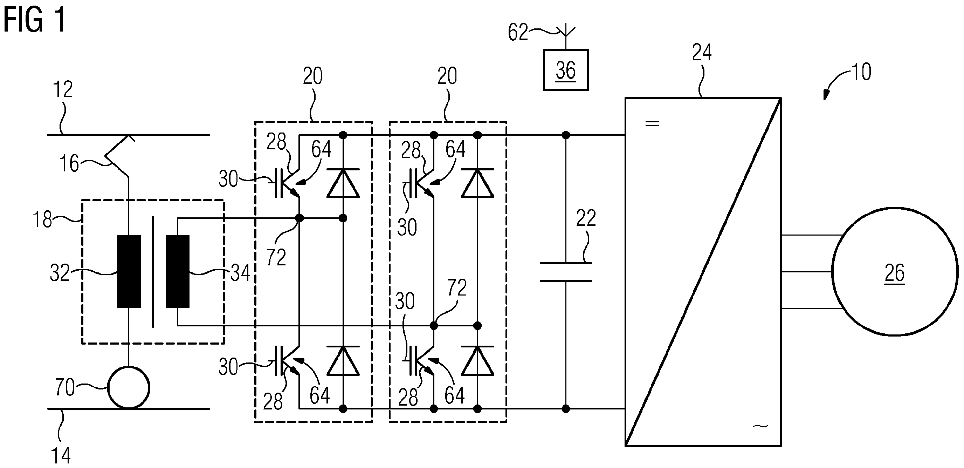

FIG 1 zeigt in einer schematischen Darstellung eines elektrisch angetriebenen Bahnfahrzeugs 10, das auf einem Gleis 14 angeordnet ist und mittels Räder 70 schienengeführt ist, von denen lediglich eines schematisch dargestellt ist. Das Bahnfahrzeug 10 umfasst einen Dachaufbau mit einem Stromabnehmer 16, der schleifend eine Oberleitung 12 kontaktiert, die oberhalb des Gleises 14 parallel zum Verlauf des Gleises 14 angeordnet ist.

Zwischen dem Stromabnehmer 16 und dem Rad 70 weist das Bahnfahrzeug 10 einen Transformator 18 mit einer Primärwicklung 32 auf, die mit einem ersten Anschluss an den Stromabnehmer 16 und mit einem zweiten Anschluss an das Rad 70 angeschlossen ist. Der Transformator 18 ist vorliegend als Trenntransformator ausgebildet. Die Primärwicklung 32 wird vorliegend mit einer Wechselspannung von etwa 15 kV bei einer Frequenz von etwa 16,7 Hz beaufschlagt. In alternativen Ausgestaltungen kann die Wechselspannung auch einen anderen Wert aufweisen, zum Beispiel etwa 25 kV oder dergleichen. Ebenso kann bei alternativen Ausgestaltungen die Frequenz auch etwa 50 Hz oder dergleichen betragen. An einer Sekundärwicklung 34 des Transformators 18 wird eine entsprechend transformierte Wechselspannung bereitgestellt, die deutlich kleiner als die Wechselspannung zwischen der Oberleitung 12 und dem Gleis 14 ist.

An die Sekundärwicklung 34 ist ein Energiewandler angeschlossen, der zwei Halbbrückenschaltungen 20 aufweist, die jeweilige IGBTs 28 als Schaltelemente umfassen. Jeder der IGBTs 28 umfasst ferner eine Inversdiode, die vorliegend jedoch nicht bezeichnet ist. Jeweilige Mittelanschlüsse 72 der Halbbrückenschaltungen 20 sind an einem jeweiligen Anschluss der Sekundärwicklung 34 angeschlossen. Die Halbbrückenschaltungen 20 sind gemeinsam an einen Zwischenkreiskondensator 22 angeschlossen. An den Zwischenkreiskondensator 22 ist ferner ein Wechselrichter 24 angeschlossen, der ein dreiphasiges Wechselspannungsnetz für eine entsprechende elektrische Maschine 26 bereitstellt, die dazu dient, wenigstens einige der Räder 70 anzutreiben.

Die IGBTs 28 weisen Steueranschlüsse 30 auf, die an eine Steuereinheit 36 angeschlossen sind. Dadurch können die IGBTs 28 individuell durch die Steuereinheit 36 derart gesteuert werden, dass sie in einem Schaltbetrieb betrieben werden können. Im Schaltbetrieb weisen die IGBT 28 lediglich den eingeschalteten Schaltzustand und den ausgeschalteten Schaltzustand auf, den sie gemäß einem Schaltsignal 38 der Steuereinheit 36 entsprechend einnehmen beziehungsweise wechseln, wenn dies durch das Schaltsignal der Steuereinheit 36 gefordert ist. Durch die Halbbrückenschaltungen 20 des Energiewandlers kann ein Vierquadrantenbetrieb in Bezug auf die Energieversorgung des Gleichspannungszwischenkreises erreicht werden.

Je nach Bedarf kann die Anzahl der Halbbrückenschaltungen 20 auch variieren.

Die vorgenannten Überlegungen gelten dem Grunde nach natürlich auch für den Wechselrichter 24. Dieser kann im vorliegenden Fall zum Beispiel drei Halbbrückenschaltungen 20 aufweisen, wobei mittels einer jeweiligen der Halbbrückenschaltungen 20 eine jeweilige Phase bereitgestellt werden kann.

Der Energiewandler mit den Halbbrückenschaltungen 20 sowie auch der Wechselrichter 24 sind vorzugsweise ausgebildet, in einem Vier-Quadranten-Betrieb betrieben zu werden.

Die vorgenannten Überlegungen gelten ferner nicht nur ZweiPunkt-Umrichter, sondern auch für Drei- oder Mehr-Punkt-Umrichter sowie für Strom- und Spannungszwischenkreisumrichter, das heißt, also auch für Matrixumrichter.

Um den Betrieb einer Gleis-Frei-Meldeanlage durch den Betrieb des Energiewandlers möglichst nicht zu stören, sollen die IGBTs 28 vorgebbare Schaltzeiträume 42 bereitstellen. Bei der Herstellung der Energiewandler sind zu diesem Zweck spezifische IGBTs 28 vorgesehen worden, sodass der vorgebbare Schaltzeitraum 42 dadurch realisiert werden kann, dass er einem schaltelementspezifischen Schaltzeitraum der IGBTs 28 entspricht. Die Schaltzeiträume sind hier also etwa gleich.

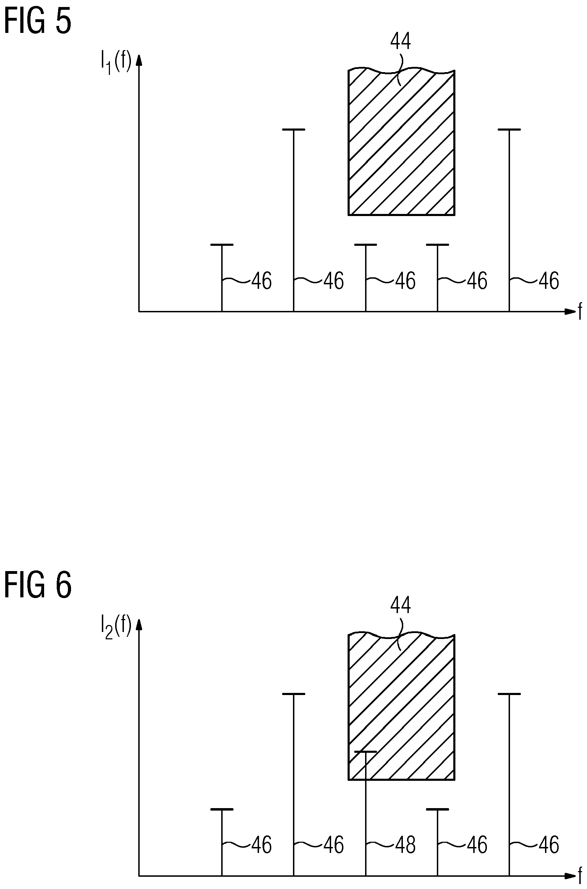

Darüber hinaus sind Impulsmuster für Schaltsignale 38 der Steuereinheit 36 entsprechend gewählt, sodass eine spektrale Verteilung bezüglich des aufgenommenen Stroms erreicht werden kann, wie er beispielsweise anhand von FIG 5 dargestellt ist. Erkennbar ist, dass dort für einige Frequenzen Amplitudenwerte 46 vorgesehen sind, die vorgegebene maximale Amplitudenwerte des Stroms bei einer spezifischen Frequenz aufweisen. Dadurch kann erreicht werden, dass ein für den Betrieb der Gleis-Frei-Meldeanlage wichtiger Frequenzbereich im Wesentlichen nicht gestört ist. Dieser Bereich ist in FIG 5 mit 44 bezeichnet.

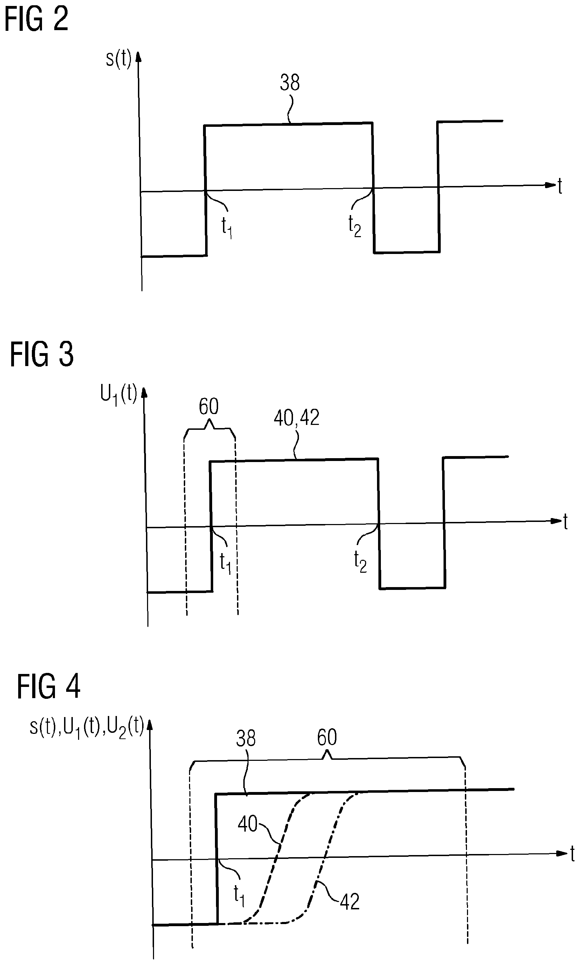

FIG 2 zeigt in einer schematischen Diagrammdarstellung ein Spannungs-Zeitdiagramm für eines der Schaltsignale 38 der Steuereinheit 36. Aus FIG 2 ist ersichtlich, dass zu Zeitpunkten $t_1$ und $t_2$ die Schaltzustände des mit diesem Schaltsignal angesteuerten IGBTs gewechselt werden.

Ist nun einer der IGBT 28 beziehungsweise mehrere oder auch alle im Rahmen einer Wartung zu wechseln, so ist zu beachten, dass neuere Versionen der IGBT 28 in der Regel aufgrund der Weiterentwicklung kürzere schaltelementspezifische Schaltzeiträume aufweisen, wie dies anhand des vergrößerten Ausschnitts aus FIG 3 in FIG 4 schematisch dargestellt ist.

FIG 3 zeigt in einer schematischen Diagrammdarstellung ein Spannungs-Zeitdiagramm für Schaltvorgänge 40, 42, wie es mittels des IGBT 28 erreicht wird. Bei der zeitlichen Auflösung gemäß FIG 3 ist ein signifikanter Unterschied zwischen dem bisherigen IGBT 28, der gegen einen neuen IGBT 28 ausgetauscht werden soll, nicht ersichtlich. Dies zeigt dagegen FIG 4, die einen Bereich 60 in einer vergrößerten zeitlichen Auflösung darstellt.

Aus der schematischen Diagrammdarstellung gemäß FIG 4 ist ersichtlich, dass der vorgebbare Schaltzeitraum 42, der durch die ursprünglich in den Halbbrückenschaltungen 20 des Energiewandlers vorgesehenen IGBT 28 mit dem Graphen 42 dargestellt ist, durch den neuen IGBT 28 deutlich unterschritten wird, wie dies anhand des Graphen 40 aus FIG 4 ersichtlich ist. Dadurch ergeben sich Veränderungen in Bezug auf die Schaltzeiten, die dazu führen können, dass Glas-Frei-Meldeanlagen nicht mehr bestimmungsgemäß zuverlässig betrieben werden können. Dies ist anhand der schematischen Diagrammdarstellung gemäß FIG 6 dargestellt, die eine schematische Diagrammdarstellung wie FIG 5 zeigt, wobei nun der IGBT 28 durch einen neuen IGBT 28 ersetzt ist, der eine schaltelementspezifische Schaltzeit gemäß dem Graphen 40, wie sie anhand von FIG 4 dargestellt ist, bereitstellt.

Aus FIG 6 ist ersichtlich, dass ein Amplitudenwert 48 in den Bereich 44 hineinragt, weshalb der bestimmungsgemäße Betrieb der Gleis-frei-Meldeanlage nicht mehr zuverlässig gewährleistet werden kann.

Um dieses Problem zu beheben, wird die Erkenntnis genutzt, dass eine identische zeitliche Verschiebung von Ein- und Ausschaltvorgängen aller IGBT 28 beziehungsweise Halbbrückenschaltungen 20 des Energiewandlers unkritisch ist, während eine schaltelementspezifische oder phasenspezifische zeitliche Verschiebung des Ein- und Ausschaltvorgangs das Frequenzspektrum massiv beeinflussen kann und zum Auftreten erwünschter Spektralanteile oder zum unzulässigen Ansteigen von Amplitudenwerten von Spektralanteilen führen kann.

Um dies zu vermeiden, wird zwischen einer Impulsmustererzeugung 56 der Steuereinheit 36 und den IGBT 28 eine Verzögerungszeiteinheit 58 wie folgt realisiert:

$$t_{delay,on} = t_{delay,on1} - t_{delay,on2}$$

$$t_{delay,off} = t_{delay,off1} - t_{delay,off2}$$

$t_{delay,on1}$ und $t_{delay,off1}$ entsprechen den schaltelementspezifischen Schaltzeiträumen des ursprünglichen IGBT 28. $t_{delay,on2}$ und $t_{delay,off2}$ entsprechen den schaltelementspezifischen Schaltzeiträumen des neuen IGBT 28, der den ursprünglichen IGBT 28 ersetzen soll.

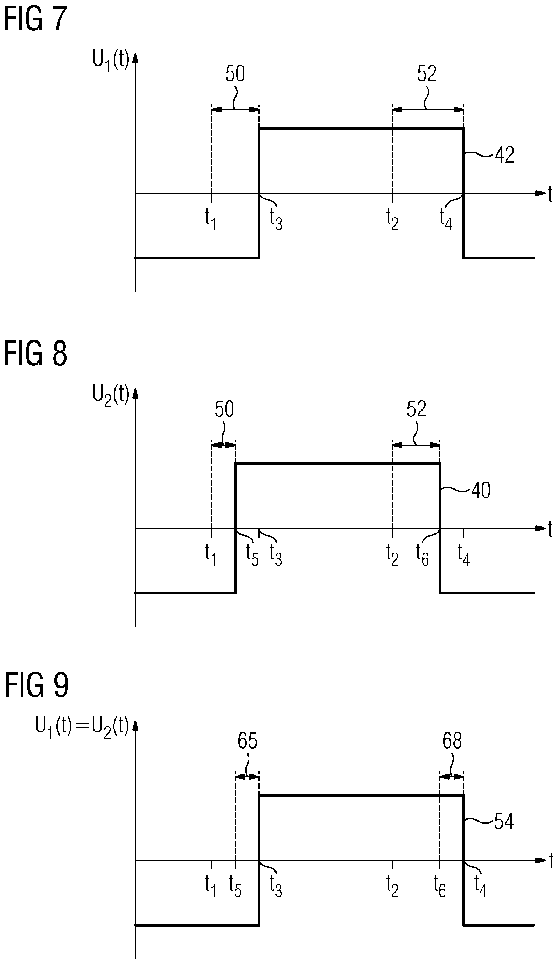

Die Auswirkungen werden anhand der schematischen Diagrammdarstellungen in den FIG 7 bis 9 erläutert, die jeweils Spannungs-Zeitdiagramme zeigen.

Danach wird die Erfindung derart ausgeführt, dass eine Korrektur der Schaltzeiträume vorgenommen wird, sodass unter Berücksichtigung des schaltelementspezifischen Schaltzeitraums 40 der vorgebbare Schaltzeitraum anhand des Graphen 54 in FIG 9 erreicht werden kann. Dieser entspricht dem schaltelementspezifischen Schaltzeitraum 42 des ursprünglich im Energiewandler angeordneten IGBT 28.

Dies kann zum Beispiel bei der Impulsmustererzeugung 56 der Steuereinheit 36 realisiert werden. Vorliegend ist jedoch vorgesehen, dass eine separate Verzögerungszeiteinheit 58 vorgesehen ist, durch die das Schaltsignal 38 hindurchgeführt wird, und die eine entsprechende zeitliche Verzögerung $t_{delay,on}$ sowie $t_{delay,off}$ gemäß der voranstehenden Formel realisiert. Diese Verzögerungszeiteinheit 58 kann in die Steuereinheit 36 integriert sein. Darüber hinaus kann sie natürlich auch in den IGBT 28 integriert sein. Im Übrigen besteht die Möglichkeit, auch eine nicht dargestellte Treiberschaltung für den IGBT 28 mit der Verzögerungszeiteinheit 58 auszurüsten und dort die entsprechende Anpassung zu realisieren.

Eine besonders anwenderfreundliche und damit vorteilhafte Implementierung der Erfindung ergibt sich dadurch, wenn die Korrektur autark beim Schaltelement beziehungsweise IGBT 28 stattfindet, weil dann ein Austausch des Schaltelements beziehungsweise IGBTs 28 ohne einen weiteren Eingriff oder Anpassung in Bezug auf die Steuereinheit 36 erfolgen kann.

Eine weitere vorteilhafte Möglichkeit kann sich dadurch ergeben, wenn die Verzögerungszeiten $t_{delay,on}$ sowie $t_{delay,off}$ oder die entsprechenden Korrekturzeiten beim Schaltelement beziehungsweise IGBT 28 gespeichert sind und diese Daten, wie zuvor beschrieben, zur Korrektur des Schaltsignals 38 genutzt werden.

Alternativ können Verzögerungszeiten $t_{delay,on/off2}$ oder auch die Korrekturzeiten $t_{delay,on}$ sowie $t_{delay,off}$ auch in einer Speichereinheit der Steuereinheit 36, einem ordentlich abgesetzten Speicher sowie auch in einer externen Datenbank, die mit der Steuereinheit 36 in Kommunikationsverbindung 62 steht, zur Verfügung gestellt werden. Die Datenbank kann zum Beispiel durch eine Cloud, eine Mindsphere und/oder dergleichen gebildet sein. Um die erforderliche Sicherheit gewährleisten zu können, können zur Datenübertragung fehlergesicherte Protokolle genutzt werden.

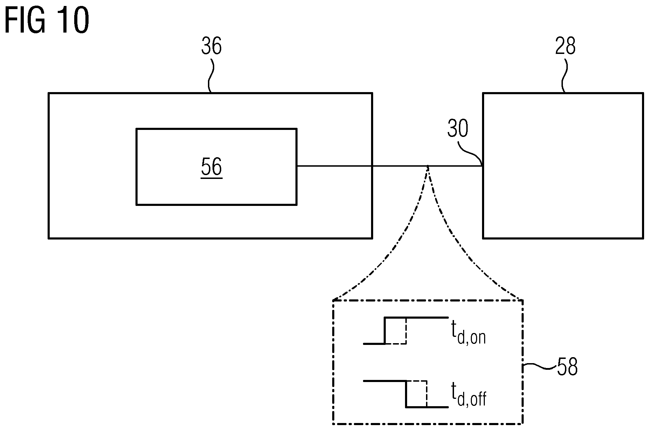

FIG 10 zeigt eine schematische Darstellung zur Realisierung der Erfindung durch zusätzliches Anordnen der Verzögerungszeiteinheit 58.

Aus der schematischen Darstellung gemäß FIG 7 ist ersichtlich, dass der vorgebbare Schaltzeitraum 42 sich dadurch ergibt, dass der ursprünglich angeordnete IGBT 28 den Einschaltvorgang nicht, wie durch das Schaltsignal 38 vorgegeben, unmittelbar zum Zeitpunkt $t_1$, sondern erst zum Zeitpunkt $t_3$ ausführt. Entsprechend verzögert sich der Wechsel vom eingeschalteten Schaltzustand zum ausgeschalteten Schaltzustand vom Zeitpunkt $t_2$ gemäß dem Schaltsignal 38 zum Zeitpunkt $t_4$. Mit 50 und 52 sind entsprechende Zeitverzüge $t_{delay,on1}$ sowie $t_{delay,off1}$ mit Pfeilen dargestellt.

FIG 8 zeigt in einer schematischen Darstellung wie FIG 7 die Verhältnisse für einen neuen IGBT 28, der kürzere schaltelementspezifische Schaltzeiträume bereitstellt. Mittels des Graphen 40 ist dies aus FIG 8 ersichtlich. Zu erkennen ist, dass der IGBT 28 aufgrund des Schaltsignals 38 den Wechsel vom ausgeschalteten Schaltzustand zum eingeschalteten Schaltzustand bereits zum Zeitpunkt $t_5$ ausführt, der vor dem Zeitpunkt $t_3$ gemäß FIG 7 liegt. Entsprechend früher liegt der Zeitpunkt zum Wechsel vom eingeschalteten Schaltzustand zum ausgeschalteten Schaltzustand, der zum Schaltzeitpunkt $t_6$ ausgeführt wird, der ebenfalls vor dem Zeitpunkt $t_4$ gemäß FIG 7 liegt. Entsprechend ergeben sich verkürzte schaltelementspezifische Schaltzeiträume $t_{delay,on2}$ sowie $t_{delay,off2}$, die anhand von Pfeilen 50, 52 im Diagramm gemäß FIG 8 dargestellt ist.

FIG 9 zeigt nun eine Darstellung zum Ermitteln von Korrekturzeiten, um den vorgebbaren Schaltzeitraum gemäß dem Graphen 54 zu erreichen. Zu diesem Zweck ist der Graph 54 in FIG 9 dargestellt, welches ebenfalls wie FIG 7 mit einem Graphen 42 in einem Spannungs-Zeit-Diagramm einem Verlauf für den vorgebbaren Schaltzeitraum, der dem schaltelementspezifischen Schaltzeitraum 42 gemäß FIG 7 entspricht, dargestellt ist. Mit Pfeilen 68 sind die entsprechenden Differenzzeiten gekennzeichnet, die durch die Verzögerungszeiteinheit 58 realisiert werden. Dadurch kann der IGBT 28 durch einen neueren IGBT 28 mit schaltelementspezifischen Schaltzeiträumen gemäß FIG 8 ausgetauscht werden, ohne dass dies Auswirkungen auf den Betrieb der Energiewandler hat und damit die Gleis-Frei-Meldeanlagen nicht stört.

Insgesamt zeigt das Ausführungsbeispiel der Erfindung, wie eine Realisierung einer vorgegebenen Eigenschaft eines Energiewandlers unabhängig von schaltelementspezifischen Schaltzeiträumen von Schaltelementen des Energiewandlers realisiert werden kann. Besonders vorteilhaft eignet sich dies für den Einsatz bei schienengeführten Fahrzeugen 10, die elektrisch angetrieben sind. Die Erfindung ist jedoch nicht hierauf beschränkt und kann auch auf andere Antriebssituationen, beispielsweise elektrisch antreibbare Fahrzeuge, oder auch Antriebsstränge, zum Beispiel für Fertigungsanlagen oder dergleichen, angewendet werden.

Der Energiewandler kann aus zwei oder drei Halbbrückenschaltungen 20 oder gegebenenfalls auch mehr gebildet sein. In Sonderfällen, insbesondere im Kleinleistungsbereich, kann eine Halbbrücke durch einen kapazitiven Spanungsteiler ersetzt sein.

Der Begriff Energiewandler kann vorliegend insbesondere sowohl einen transformatorseitigen Vierquadrantensteller als auch einen maschinenseitigen Impulswechselrichter umfassen. Der Energiewandler kann dem Grunde nach jedoch auch einen Gleichspannungswandler, beispielsweise einen DC/DC-Wandler, oder dergleichen umfassen.

Das Ausführungsbeispiel dient ausschließlich der Erläuterung der Erfindung und soll diese nicht beschränken.

**Patentansprüche**

1. Energiewandler (20) zum Wandeln von elektrischer Energie, mit:

   - wenigstens einem steuerbaren Schaltelement (28), das wenigstens einen schaltelementspezifischen Schaltzeitraum (40) bereitstellt, den das Schaltelement (28) benötigt, um abhängig von einem an einem Steueranschluss (30) des Schaltelements (28) bereitgestellten Schaltsignal (38) einen Schaltzustand einer Schaltstrecke (64) des Schaltelements (28) zwischen einem ausgeschalteten Schaltzustand und einem eingeschalteten Schaltzustand zu wechseln, sowie
   - einer Steuereinheit (36), die ausgebildet ist, das Schaltsignal (38) derart bereitzustellen, dass das Schaltelement (28) zum Wandeln der elektrischen Energie abhängig vom Schaltsignal (38) in einem Schaltbetrieb betrieben wird,

   **dadurch gekennzeichnet, dass**

   - die Steuereinheit (36) ferner ausgebildet ist, das Schaltsignal (38) in Bezug auf einen Zeitpunkt abhängig von dem wenigstens einen schaltelementspezifischen Schaltzeitraum (40) derart bereitzustellen, dass im bestimmungsgemäßen Betrieb des Energiewandlers (20) mit dem steuerbaren Schaltelement (28) wenigstens ein vorgebbarer Schaltzeitraum (42) an dem Zeitpunkt erreicht wird.

2. Energiewandler nach Anspruch 1, **gekennzeichnet durch** eine Kommunikationsverbindung zwischen der Steuereinheit (36) und dem Schaltelement (28), die ausgebildet ist, Daten bezüglich des wenigstens einen schaltelementspezifischen Schaltzeitraum (40) und/oder des wenigstens einen vorgebbaren Schaltzeitraum (42) zwischen der Steuereinheit (36) und dem Schaltelement (28) zu übermitteln.

3. Energiewandler nach einem der vorhergehenden Ansprüche,
   **dadurch gekennzeichnet, dass** die Steuereinheit (36) eine Speichereinheit mit den Daten bezüglich des wenigstens einen schaltelementspezifischen Schaltzeitraum (40) und/oder des wenigstens einen vorgebbaren Schaltzeitraum (42) umfasst.

4. Energiewandler nach einem der vorhergehenden Ansprüche,
   **dadurch gekennzeichnet, dass** die Steuereinheit (36) ausgebildet ist, dem wenigstens einen schaltelementspezifischen Schaltzeitraum (40) und/oder dem wenigstens einen vorgebbaren Schaltzeitraum (42) entsprechende Daten aus einer Datenbank abzurufen, die mit der Steuereinheit (36) zumindest zeitweise in Kommunikationsverbindung (62) steht.

5. Energiewandler nach einem der vorhergehenden Ansprüche,
   **dadurch gekennzeichnet, dass** die Steuereinheit (36) ausgebildet ist, das Steuersignal (38) abhängig vom wenigstens einen schaltelementspezifischen Schaltzeitraum (40) und/oder vom wenigstens einen vorgebbaren Schaltzeitraum (42) zu ermitteln.

6. Energiewandler nach einem der vorhergehenden Ansprüche,
   **dadurch gekennzeichnet , dass** der wenigstens eine Schaltzeitraum (40,42) ein Einschaltzeitraum und/oder ein Ausschaltzeitraum ist.

7. Schaltelement (28) für einen Energiewandler (20), mit:

   - wenigstens einem Steueranschluss (30) zum Beaufschlagen mit einem Schaltsignal, und
   - einer Schaltstrecke (64), die ausgebildet ist, einen Schaltzustand abhängig vom Schaltsignal am Steueranschluss (30) bereitzustellen, wobei die Schaltstrecke (64) wenigstens einen schaltelementspezifischen Schaltzeitraum (40) bereitstellt, die das Schaltelement (28) benötigt, um den Schaltzustand der Schaltstrecke (64) zwischen einem ausgeschalteten Schaltzustand und einem eingeschalteten Schaltzustand zu wechseln,

**dadurch gekennzeichnet, dass** das Schaltelement (28) ausgebildet ist, das Schaltsignal in Bezug auf einen Zeitpunkt abhängig vom wenigstens einen schaltelementspezifischen Schaltzeitraum (40) derart zeitlich zu beeinflussen, dass im bestimmungsgemäßen Betrieb des Energiewandlers (28) mit dem steuerbaren Schaltelement (28) wenigstens ein vorgebbarer Schaltzeitraum (42) ab dem Zeitpunkt erreicht wird.

8. Schaltelement nach Anspruch 7, **gekennzeichnet durch** ein Speicherelement zum Speichern von Daten bezüglich des wenigstens einen vorgebbaren Schaltzeitraums (42) und/oder des wenigstens einen schaltelementspezifischen Schaltzeitraums (40).

9. Schaltelement nach Anspruch 7 oder 8, **dadurch gekennzeichnet , dass** der Schaltzeitraum (40, 42) ein Einschaltzeitraum und/oder ein Ausschaltzeitraum ist.

10. Schaltelement nach einem der Ansprüche 7 bis 9, **gekennzeichnet durch** einen Kommunikationsschnittstellenanschluss zum Übermitteln der Daten bezüglich des vorgebbaren Schaltzeitraums (42) und/oder des schaltelementspezifischen Schaltzeitraums (40).

11. Elektrisch antreibbares Fahrzeug (10), insbesondere schienengeführtes elektrisch antreibbares Fahrzeug, mit:

- einer elektrischen Maschine (26) zum Antreiben des Fahrzeugs (10), und
- wenigstens einem mit der elektrischen Maschine (26) elektrisch gekoppelten Energiewandler (20,22,24),

**dadurch gekennzeichnet, dass**

- der Energiewandler (20) nach einem der Ansprüche 1 bis 6 ausgebildet ist, oder
- der Energiewandler (20) ein steuerbares Schaltelement (28) aufweist, das nach einem der Ansprüche 7 bis 10 ausgebildet ist.

12. Verfahren zum Betreiben eines Energiewandlers (20), der elektrische Energie wandelt, indem ein steuerbares Schaltelement (28) in einem Schaltbetrieb betrieben wird, bei dem:

- das steuerbare Schaltelement (28) wenigstens einen schaltelementspezifischen Schaltzeitraum (40) bereitstellt, die das Schaltelement (28) benötigt, um abhängig von einem Schaltsignal einen Schaltzustand einer Schaltstrecke (64) des Schaltelements (28) zwischen einem ausgeschalteten Schaltzustand und einem eingeschalteten Schaltzustand zu wechseln, und
- das Schaltsignal derart bereitgestellt wird, dass das Schaltelement (28) im Schaltbetrieb betrieben wird,

**dadurch gekennzeichnet, dass**

- das Schaltsignal in Bezug auf einen Zeitpunkt abhängig vom wenigstens einen schaltelementspezifischen Schaltzeitraum (40) derart bereitgestellt wird, dass im bestimmungsgemäßen Betrieb des Energiewandlers (20) mit dem steuerbaren Schaltelement (28) wenigstens ein vorgebbarer Schaltzeitraum (42) ab dem Zeitpunkt erreicht wird.

13. Verfahren nach Anspruch 12, **dadurch gekennzeichnet**, dass als Schaltsignal (40, 42) ein Einschaltsignal und/oder ein Ausschaltsignal ermittelt wird.

14. Verfahren nach einem der Ansprüche 12 oder 13, **dadurch gekennzeichnet , dass** das Schaltsignal (40, 42) ergänzend abhängig von einem elektrischen Strom und/oder einer elektrischen Spannung und/oder einer Temperatur des Energiewandlers, insbesondere des Schaltelements (28) ermittelt wird.

15. Verfahren nach einem der Ansprüche 12 bis 14, **dadurch gekennzeichnet , dass** der wenigstens eine vorgebbare Schaltzeitraum (42) größer als der wenigstens eine schaltelementspezifische Schaltzeitraum (40) ist.

16. Verfahren nach einem der Ansprüche 12 bis 15, **dadurch gekennzeichnet , dass** der wenigstens eine schaltelementspezifische Schaltzeitraum (40) in einem bestimmungsgemäßen Betrieb des Energiewandlers (20) ermittelt wird.

FIG 1

10

26

24

22

36

62

20

64

28

30

72

64

28

30

20

64

28

30

72

64

28

30

34

32

18

16

12

70

14

FIG 2

$s(t)$

38

$t_1$        $t_2$

t

FIG 3

$U_1(t)$

60        40,42

$t_1$        $t_2$

t

FIG 4

$s(t), U_1(t), U_2(t)$

38        60

40

$t_1$

42

t

FIG 5

$I_1(f)$

44

~46   ~46   ~46   ~46   ~46

f

FIG 6

$I_2(f)$

44

~46   ~46   ~48   ~46   ~46

f

FIG 7

FIG 8

FIG 9

# FIG 10

36

28

56

30

$t_{d,on}$

$t_{d,off}$

58

Europäisches Patentamt
European Patent Office
Office européen des brevets

# EUROPÄISCHER RECHERCHENBERICHT

Nummer der Anmeldung

EP 18 17 4844

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2008/094121 A1 (NAKAMORI AKIRA [JP] ET AL) 24. April 2008 (2008-04-24) * Absatz [0043] - Absatz [0068]; Anspruch 2; Abbildungen 1-3, 7 * ----- | 1-16 | INV. H02M7/5395 H02P27/08 B61L21/06 H03K17/567 |
| A | US 4 339 697 A (FRANZ JAMES H) 13. Juli 1982 (1982-07-13) * Spalten 1,4-5; Abbildung 5 * ----- | 1-16 | |
| A | US 2009/066402 A1 (HIYAMA KAZUAKI [JP]) 12. März 2009 (2009-03-12) * Absatz [0142]; Anspruch 1; Abbildungen 1,16 * ----- | 1-16 | |

RECHERCHIERTE SACHGEBIETE (IPC)

H02M
H02P
B61L
H03K

Der vorliegende Recherchenbericht wurde für alle Patentansprüche erstellt

| Recherchenort | Abschlußdatum der Recherche | Prüfer |
|---|---|---|
| München | 31. Oktober 2018 | Kruip, Stephan |

**ANHANG ZUM EUROPÄISCHEN RECHERCHENBERICHT
ÜBER DIE EUROPÄISCHE PATENTANMELDUNG NR.**

EP 18 17 4844

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-10-2018

| Im Recherchenbericht angeführtes Patentdokument | Datum der Veröffentlichung | Mitglied(er) der Patentfamilie | Datum der Veröffentlichung |
|---|---|---|---|
| US 2008094121 A1 | 24-04-2008 | KEINE | |
| US 4339697 A | 13-07-1982 | BE 888791 A<br>BR 8102896 A<br>CA 1152611 A<br>ES 8300211 A1<br>FR 2482798 A1<br>IT 1146870 B<br>JP S576501 A<br>US 4339697 A | 13-11-1981<br>02-02-1982<br>23-08-1983<br>01-10-1982<br>20-11-1981<br>19-11-1986<br>13-01-1982<br>13-07-1982 |
| US 2009066402 A1 | 12-03-2009 | JP 2009071956 A<br>US 2009066402 A1<br>US 2010148846 A1 | 02-04-2009<br>12-03-2009<br>17-06-2010 |

EPO FORM P0461

Für nähere Einzelheiten zu diesem Anhang : siehe Amtsblatt des Europäischen Patentamts, Nr.12/82